# EUROPÄISCHE PATENTSCHRIFT

(11) **EP 2 444 283 B1**
(45) Veröffentlichungstag und Bekanntmachung des Hinweises auf die Patenterteilung: **19.02.2020**
(21) Anmeldenummer: 11008148.6
(22) Anmeldetag: 07.10.2011
(51) Int. Cl.: B60Q 1/26, B60R 1/12

(54) **Lichtmodul**
Light module
Module d'éclairage

(30) Priorität: 20.10.2010 DE 102010048801
(43) Veröffentlichungstag der Anmeldung: 25.04.2012
(73) Patentinhaber: Mektec Europe GmbH, 41812 Erkelenz (DE)
(72) Erfinder: Böhland, Heiko, 12309 Berlin (DE); Runge, Olaf, 10318 Berlin (DE); Renner, Guido, 69469 Weinheim (DE)
(74) Vertreter: Wesch, Arno

(56) Entgegenhaltungen:
- WO-A1-2004/113123
- WO-A2-2004/024502
- US-A1- 2005 201 113
- US-A1- 2007 053 179
- US-B1- 7 717 596
- US-B2- 7 334 922

## Beschreibung

### Technisches Gebiet

Die Erfindung betrifft ein Lichtmodul gemäß dem Oberbegriff des Patentanspruchs 1.

### Stand der Technik

Ein solches Lichtmodul ist aus der WO 2004/ 113 123 A1 bekannt.

Ein weiteres Lichtmodul zur Anordnung in einem Rückspiegel eines Kraftfahrzeugs ist aus der US 7,334,922 B2 bekannt.

Ein weiteres Lichtmodul ist zum Beispiel aus der WO 2004/024502 A1 bekannt. Das bekannte Lichtmodul, das auf der Rückseite des Spiegelglases eines Rückblickspiegels eines Kraftfahrzeugs angeordnet ist, besteht aus einer starren Platine, welche auf der der Rückseite des Spiegelglases zugewandten Seite mit LEDs bestückt ist. Für die Verbindung der Platine mit einer außerhalb des Spiegels angeordneten Strom-/Spannungsversorgung bzw. einer Steuerungseinrichtung sind in der Druckschrift Kabel vorgesehen. Mit Hilfe der LEDs werden in der Spiegelglasfläche besondere Fahr-oder Umgebungssituationen des Kraftfahrzeugs, wie zum Beispiel eingeschaltetes Blinklicht, Fahrzeug im Totwinkelbereich usw., über unterschiedliche ausgeleuchtete Symbole angezeigt.

Nachteilig an dem bekannten Lichtmodul ist, dass der Aufbau sehr komplex ist und es sehr viel Bauraum benötigt.

### Darstellung der Erfindung

Aufgabe der Erfindung ist, ein Lichtmodul der eingangs genannten Art so weiter zu bilden, dass es einfach und kostengünstig herstellbar ist und wenig Bauraum benötigt.

Diese Aufgabe wird gelöst mit einem Lichtmodul gemäß Patentanspruch 1 . Patentanspruch 13 beschreibt eine bevorzugte Verwendung eines erfindungsgemäßen Lichtmoduls,

Ein erfindungsgemäßes Lichtmodul zur Signalanzeige im Rückblickspiegel eines Kraftfahrzeugs, umfasst einen Schaltungsträger, auf welchem wenigstens ein Leuchtmittel und ggf. weitere elektronische Bauteile angeordnet sind, und eine Stromzuführung zum Verbinden des Schaltungsträgers mit einer von dem Schaltungsträger beanstandet angeordneten Schnittstelle zu Anschlussmitteln zum Verbinden mit einer Strom-/ Spannungsversorgung und/oder Steuerungseinrichtung. Erfindungsgemäß ist bei einem Lichtmodul der oben genannten Art vorgesehen, dass der Schaltungsträger und die Stromzuführung materialeinheitlich und einstückig ausgebildet sind und durch eine flexible Leiterplatte gebildet werden.

Ein erfindungsgemäßes Lichtmodul zeichnet sich dadurch aus, dass der Schaltungsträger und die Schnittstelle zur Stromversorgung bzw. zu einer Steuerungseinheit räumlich voneinander getrennt sind. Durch den Wegfall von Stromanschlüssen an dem Schaltungsträger selbst werden weniger Bauteile benötigt und das Lichtmodul kann relativ kleinvolumig ausgestaltet werden, so dass es nur wenig Bauraum benötigt und einfach zu montieren ist. Dadurch werden auch die Kosten reduziert.

In einer bevorzugten Ausführungsform der Erfindung umfassen die Leuchtmittel SIDE- und/oder TOP LEDs. Diese können weißes und/oder farbiges Licht abstrahlen. Die Leuchtfläche kann zur Erzeugung gewünschter Signale insbesondere auch mehrfarbig ausgeleuchtet werden.

Vorteilhafterweise wird die Anordnung der Leuchtmittel auf dem Schaltungsträger an die Kontur der auszuleuchtenden Fläche angepasst.

Zur Einstellung des Abstrahlwinkels des Lichts kann wenigstens ein Lichtformungselement vorgesehen sein. Das Lichtformungselement, das die Aufgabe hat, das aus den Leuchtmitteln austretende Licht auf den Fahrgastraum hin zu lenken, kann beispielsweise durch einen einfachen Lichtleiter gebildet werden. Aber auch andere optische Elemente, mit deren Hilfe sich der Strahlengang des Lichts beeinflussen lässt, sind denkbar.

Vorteilhafterweise weisen der Schaltungsträger, die Leuchtmittel, die ggf. vorhandenen weiteren elektronischen Bauteile und das Lichtformungselement einen flachen sandwichartigen Aufbau auf. Bei dieser Ausführungsform wird besonders wenig Bauraum benötigt, das Modul ist einfach zu handhaben und unterzubringen.

In einer weiteren bevorzugten Ausführungsform der Erfindung wird das Lichtformungselement so angeordnet, dass der Schaltungsträger mit den Leuchtmitteln und den ggf. vorhandenen weiteren elektronischen Bauteilen nach außen hin abgedichtet wird. Damit sind die elektronischen Bauteile beispielsweise vor eindringendem Staub und sonstigen Verunreinigungen geschützt, ohne dass weitere Bauelemente hierfür benötigt werden. Die einzelnen Komponenten können noch zusätzlich miteinander verklebt werden.

Zur gleichmäßigen Ausleuchtung der zu beleuchtenden Fläche kann in an sich bekannter Weise ein Diffusor, insbesondere eine Diffusorfolie, vorgesehen sein. Ebenso können Maskierungen zur Erzeugung gewünschter Symbole in der auszuleuchtenden Fläche vorgesehen sein.

Gemäß einer weiteren bevorzugten Ausführungsform der Erfindung ist die flexible Leiterplatte im Bereich der Stromzuführung als streifenförmige Leiterbahn ausgebildet.

Der Schaltungsträger kann auch in eine flexible Leiterplatte, die der Bereitstellung weiterer Zusatzfunktionen, wie z. B. eine Heiz- und/oder eine Antennenfunktion oder eine sonstige Lichtfunktion, dient, integriert werden. Die Stromzuführung bzw. der Kontakt zu einer Steuerungseinheit erfolgt in diesem Fall über die flexible Leiterplatte. Hierbei muss der Schaltungsträger mit den Leuchtmitteln nur so positioniert werden, dass die Leuchtmittel im montierten Zustand im Rückblickspiegel durch ein Signalfenster des Rückblickspiegels sichtbar sind.

Der Schaltungsträger ist am äußeren Rand der flexiblen Leiterplatte so angeordnet, dass er bei der Montage durch Umklappen oder -biegen der streifenförmigen Leiterbahn nach innen in den Bereich des Signalanzeigefensters des Rückblickspiegels bringbar ist. Hierzu kann das Lichtmodul beispielsweise vom Rand der flexiblen Leiterplatte nach außen abragen. Die streifenförmige Leiterbahn kann hierbei einstückig und materialeinheitlich mit der flexiblen Leiterplatte ausgebildet werden. Es kann aber auch eine Schnittstelle zwischen dem Lichtmodul und der flexiblen Leiterplatte vorgesehen sein.

Auch bei dieser Ausführungsform ist der Schaltungsträger mit den Leuchtmitteln so positioniert, dass die Leuchtmittel im montierten Zustand durch ein Signalanzeigefenster des Rückblickspiegels sichtbar sind. Hierzu kann die flexible Leiterplatte beispielsweise eine entsprechende Aussparung aufweisen. Der Schaltungsträger kann bei einem sandwichartigen Aufbau direkt an das Signalfenster heran geklappt werden. Er kann aber auch beabstandet angeordnet werden, wobei der Diffusor und das Lichtformungselement im Bereich des Signaffensters vorgesehen sein können.

Ein erfindungsgemäßes Lichtmodul wird vorzugweise zur Signalanzeige in einem Rückblickspiegel eines Kraftfahrzeugs eingesetzt. Es kann hierbei sowohl in der Spiegelglasfläche als auch im Bereich des Spiegelfußes angeordnet werden.

Vorzugsweise wird es zur Totwinkelanzeige eingesetzt. Es ist jedoch keineswegs auf diese Art der Anzeige beschränkt. Hinsichtlich der Einsatzmöglichkeiten gibt es keine Beschränkungen. Es sind trotz einfachem Aufbau mit möglichst wenigen Komponenten beliebige Symbole mit beliebiger Farbgebung realisierbar.

### Kurzbeschreibung der Zeichnung

Nachfolgend wird die Erfindung anhand der Figuren näher erläutert

Es zeigen:
- Fig.1a, b, c: in schematischer Darstellung ein Lichtmodul gemäß einer bevorzugten Ausführungsform der Erfindung in verschiedenen Ansichten;
- Fig. 2: in einer schematischen Darstellung in Draufsicht ein erfindungsgemäßes Lichtmodul, das in eine Heizfolie integriert ist;
- Fig. 3a, b: in einer schematischen Darstellung in Draufsicht ein erfindungsgemäßes Lichtmodul, welches am Randbereich einer Heizfolie angeordnet ist;
- Fig. 4: das Lichtmodul aus Fig. 3, aber mit einer Schnittstelle zur Heizfolie;
- Fig. 5: in einer schematischen Darstellung in seitlicher Ansicht ein in eine Heizfolie integriertes erfindungsgemäßes Lichtmodul gemäß einer weiteren Ausführungsform der Erfindung.

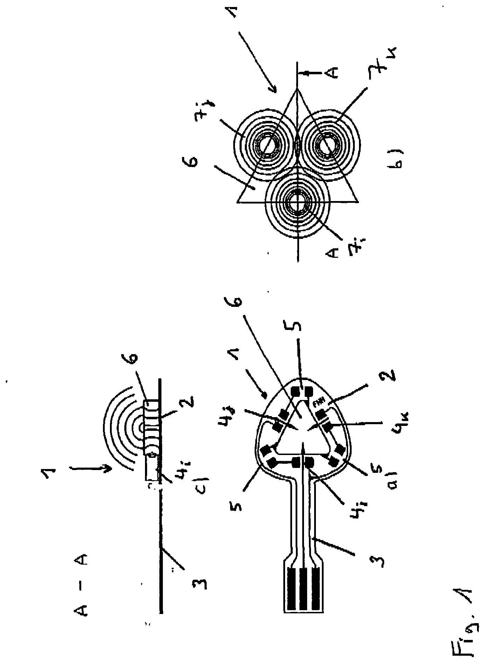

Man erkennt in Fig. 1 ein Lichtmodul 1 gemäß einer bevorzugten Ausführungsform der Erfindung. Das Lichtmodul 1 ist ohne Beschränkung der Allgemeinheit als separates Bauteil ausgebildet. Fig. 1 a) zeigt das Lichtmodul 1 in Draufsicht. In Fig. 1 b) ist in schematischer Darstellung die Lichtverteilung dargestellt. Fig. 1c) zeigt einen Ausschnitt einer Querschnittsdarstellung eines erfindungsgemäßen Lichtmoduls 1. Das erfindungsgemäße Lichtmodul 1 ist in der Figur ohne Beschränkung der Allgemeinheit als separates Bauteil ausgebildet. Auf einem Schaltungsträger 2 mit einer Stromzuführung 3 sind drei SIDE-LEDs 4i, 4j, 4k, sowie weitere elektronische Bauteile 5 angeordnet. Die Stromzuführung 3 dient zum Verbinden des Schaltungsträgers 2 mit einer von dem Schaltungsträger 2 beanstandet angeordneten, hier nicht dargestellten Schnittstelle zu Anschlussmitteln zum Verbinden mit einer Strom-/Spannungsversorgung und/oder Steuerungseinrichtung.

Erfindungsgemäß sind der Schaltungsträger 2 und die Stromzuführung 3 materialeinheitlich und einstückig ausgebildet und werden durch eine flexible Leiterplatte gebildet. In der dargestellten Ausführungsform der Erfindung ist die Anordnung der SIDE LED's 4i, 4j. 4k, auf dem Schaltungsträger 2 an die Kontur der auszuleuchtenden Fläche, hier ohne Beschränkung der Allgemeinheit ein Dreieck, angepasst. In Fig. 1b) sind schematisch die von den Leuchtmitteln abgestrahlten Lichtkegel 7i, 7j und 7k dargestellt. Zur Einstellung des Abstrahlwinkels des Lichts ist wenigstens ein Lichtleiter 6 vorgesehen, der in der dargestellten Ausführungsform die Dreiecksfläche zwischen den SIDE-LEDs 4i, 4j. 4k, vollständig ausfüllt und diese wie auch den Schaltungsträger 2 nach außen hin abdichtet Das Eindringen von Staub oder sonstigen Verunreinigungen wird dadurch wirksam verhindert.

Man erkennt in den Figuren, dass der Schaltungsträger 2, die SIDE-LEDs 4i, 4j und 4k und die weiteren elektronischen Bauteile 5 und der Lichtleiter 6 einen flachen sandwichartigen Aufbau aufweisen.

Die Stromzuführung 3 ist in der dargestellten Ausführungsform als streifenförmige Leiterbahn (Flex Tail) ausgebildet.

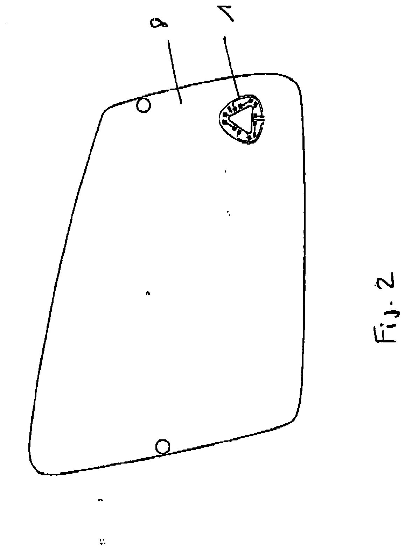

Fig. 2 zeigt eine Flächenheizfolie 8, deren Außenkontur zur Beheizung einer hier nicht dargestellten Spiegelglasfläche eines Rückblickspiegels an deren Außenkontur angepasst ist. Die Verwendung einer Flächenheizfolie 8 bei der vorliegenden Ausführungsform ist jedoch nur beispielhaft. Es könnte sich ebenso gut um eine flexible Leiterplatte für eine Antennenfunktion oder eine andere Lichtfunktion oder einen Leitungssatz oder eine sonstige Funktion handeln. Bei dieser Ausführungsform ist das Lichtmodul bzw. der Schaltungsträger 2 des Lichtmoduls 1 in die Heizfolie 8 integriert.

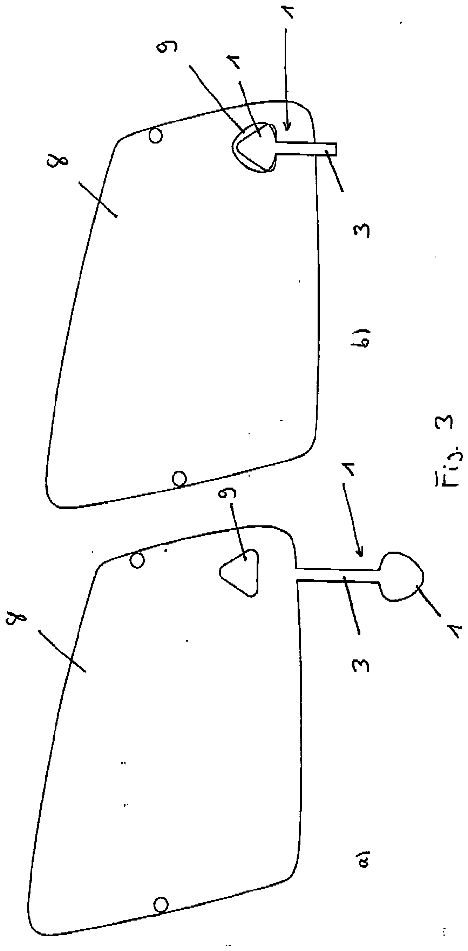

Bei der in Fig. 3 dargestellten Ausführungsform der Erfindung ist der Schaltungsträger 2 mit der streifenförmigen Leiterbahn 3 ebenfalls integraler Bestandteil der Heizfolie 8. Die streifenförmige Leiterbahn 3 und der Schaltungsträger 2 ragen jedoch vom Rand der Heizfolie nach außen ab, so dass der Schaltungsträger 2 erst durch Umklappen der streifenförmigen Leiterbahn 3 in den Bereich des Signalanzeigefensters des Rückblickspiegels bringbar ist. Die Heizfolie 8 weist im Bereich des Signalanzeigefensters eine Aussparung 9 auf.

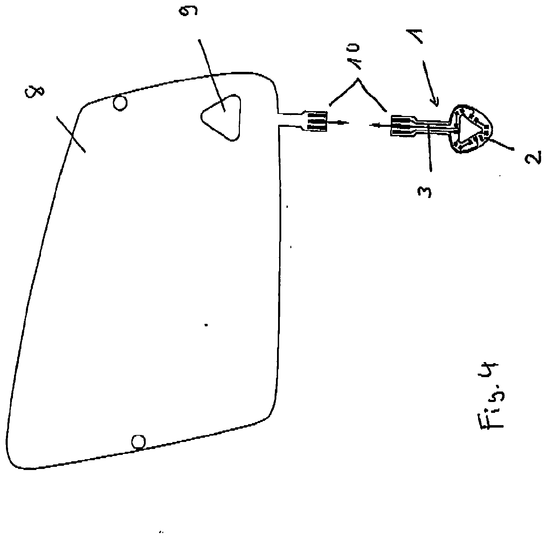

In Figur 4 ist eine Schnittstelle 10 zwischen der Heizfolie 8 und der streifenförmigen Leiterbahn 3 mit dem Schaltungsträger 2 vorgesehen. Auch bei dieser Ausführungsform ist das Lichtmodul als separates Bauteil ausgebildet.

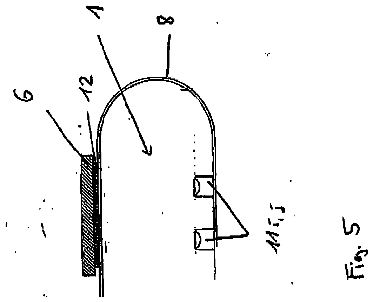

In Fig. 5 ist eine Ausführungsform eines erfindungsgemäßen Lichtmoduls 1 erkennbar, bei welchem der Schaltungsträger 2 mit den Leuchtmitteln, hier TOP-LEDs 11i, 11j, 11 k, in die Heizfolie 8 integriert, aber beabstandet von dem Signalanzeigefenster des Rückblickspiegels angeordnet ist. Auch die optischen Elemente, d. h. der Lichtleiter 6 und die Diffusorfolie 12 sind beabstandet oberhalb der Leuchtmittel angeordnet.

## Patentansprüche

1. Lichtmodul (1) zur Signalanzeige im Rückblickspiegel eines Kraftfahrzeugs, umfassend einen Schaltungsträger (2), auf welchem wenigstens ein Leuchtmittel und ggf. weitere elektronische Bauteile angeordnet sind, und eine Stromzuführung zum Verbinden des Schaltungsträgers (2) mit einer von dem Schaltungsträger (2) beanstandet angeordneten Schnittstelle zu Anschlussmitteln zum Verbinden mit einer Strom-/ Spannungsversorgung und/oder Steuerungseinrichtung,
wobei der Schaltungsträger (2) und die Stromzuführung materialeinheitlich und einstückig ausgebildet sind und durch eine flexible Leiterplatte gebildet werden,
wobei wenigstens eine weitere flexible Leiterplatte mit wenigstens einer Zusatzfunktion vorgesehen ist und wobei der Schaltungsträger (2) mit einer streifenförmigen Leiterbahn (3) nach außen abragend am Randbereich der weiteren flexiblen Leiterplatte angeordnet und durch Umklappen bzw. Umbiegen der streifenförmigen Leiterbahn (3) in eine gewünschte Position bringbar ist,
**dadurch gekennzeichnet, dass**
die weitere flexible Leiterplatte eine Aussparung (9) aufweist und dass der Schaltungsträger (2) durch Umklappen der streifenförmigen Leiterbahn (3) in den Bereich der Aussparung (9) bringbar ist.

2. Lichtmodul (1) nach Anspruch 1, **dadurch gekennzeichnet, dass** die Leuchtmittel SIDE- und/oder TOP LEDs umfassen.

3. Lichtmodul (1) nach Anspruch 1 oder 2, **dadurch gekennzeichnet, dass** die Anordnung der Leuchtmittel auf dem Schaltungsträger (2) an die Kontur einer auszuleuchtenden Fläche angepasst ist.

4. Lichtmodul (1) nach einem der Ansprüche 1 bis 3, **dadurch gekennzeichnet, dass** zur Einstellung des Abstrahlwinkels des Lichts wenigstens ein Lichtformungselement vorgesehen ist.

5. Lichtmodul (1) nach einem der Ansprüche 1 bis 4, **dadurch gekennzeichnet, dass** der Schaltungsträger (2), die Leuchtmittel, die ggf. vorhandenen weiteren elektronischen Bauteile und das Lichtformungselement einen flachen sandwichartigen Aufbau aufweisen.

6. Lichtmodul (1) nach Anspruch 5, **dadurch gekennzeichnet, dass** das Lichtformungselement den Schaltungsträger (2) mit den Leuchtmitteln und den ggf. vorhandenen weiteren elektronischen Bauteilen (5) nach außen hin abdichtet.

7. Lichtmodul (1) nach einem der Ansprüche 1 bis 6, **dadurch gekennzeichnet, dass** ein Diffusor (12) zur Streuung des Lichts vorgesehen ist.

8. Lichtmodul (1) nach einem der Ansprüche 1 bis 7, **dadurch gekennzeichnet, dass** eine Maskierung zur Erzeugung eines gewünschten Symbols in der auszuleuchtenden Fläche vorgesehen ist.

9. Lichtmodul (1) nach einem der Ansprüche 1 bis 8, **dadurch gekennzeichnet, dass** die flexible Leiterplatte im Bereich der Stromzuführung als streifenförmige Leiterbahn (3) ausgebildet ist

10. Lichtmodul (1) nach einem der voranstehenden Ansprüche, **dadurch gekennzeichnet, dass** der Schaltungsträger (2), der durch die flexible Leiterplatte gebildet wird, in die weitere flexible Leiterplatte mit der Zusatzfunktion integriert ist.

11. Lichtmodul (1) nach einem der Ansprüche 1 bis 9, **dadurch gekennzeichnet, dass** zwischen der weiteren flexiblen Leiterplatte mit der Zusatzfunktion und der streifenförmigen Leiterbahn (3) eine Schnittstelle (10) vorgesehen ist.

12. Lichtmodul (1) nach einem der voranstehenden Ansprüche, **dadurch gekennzeichnet, dass** die Zusatzfunktion eine Heiz-, Antennen-, Stromleitung- oder andere Lichtfunktion ist.

13. Verwendung eines Lichtmoduls nach einem der Ansprüche 1 bis 12 in einem Rückblickspiegel für Kraftfahrzeuge.

14. Verwendung nach Anspruch 13, **dadurch gekennzeichnet, dass** das Lichtmodul direkt unterhalb der Spiegelglasfläche des Rückblickspiegels angeordnet ist.

15. Verwendung nach Anspruch 13, **dadurch gekennzeichnet, dass** es im Spiegelfuß des Rückblickspiegels angeordnet ist.

16. Verwendung nach einem der Ansprüche 13 bis 15, **dadurch gekennzeichnet, dass** das Lichtmodul zur Totwinkelanzeige vorgesehen ist.

## Claims

1. Light module (1) for signal display in the rear view mirror of a motor vehicle, comprising a circuit carrier (2) on which there are arranged at least one luminous means and, if appropriate, further electronic subassemblies, and a power lead for connecting the circuit carrier (2) to an interface, arranged at a spacing from the circuit carrier (2), with connection means for connecting to a power supply unit and/or control device,
the circuit carrier (2) and the power lead being integrally constructed from the same material and being formed by a flexible printed circuit board, at least one further flexible printed circuit board with at least one additional function being provided, and the circuit carrier (2) being arranged with a strip-shaped conductor track (3) projecting outwards on the edge region of the further flexible printed circuit board, and being able to be brought into a desired position by folding down or bending over the strip-shaped conductor track (3),
**characterized in that**
the further flexible printed circuit board has a cutout (9), and **in that** the circuit carrier (2) can be brought into the region of the cutout (9) by folding down the strip-shaped conductor track (3) .

2. Light module (1) according to Claim 1, **characterized in that** the luminous means comprise SIDE and/or TOP LEDs.

3. Light module (1) according to Claim 1 or 2, **characterized in that** the arrangement of the luminous means on the circuit carrier (2) is adapted to the contour of an area to be illuminated.

4. Light module (1) according to one of Claims 1 to 3, **characterized in that** at least one light-shaping element is provided for setting the emission angle of the light.

5. Light module (1) according to one of Claims 1 to 4, **characterized in that** the circuit carrier (2), the luminous means, the further electronic subassemblies present if appropriate, and the light-shaping element have a flat sandwich-type structure.

6. Light module (1) according to Claim 5, **characterized in that** the light-shaping element seals off the circuit carrier (2) with the luminous means and the further electronic subassemblies (5) optionally present from the outside.

7. Light module (1) according to one of Claims 1 to 6, **characterized in that** a diffuser (12) is provided for scattering the light.

8. Light module (1) according to one of Claims 1 to 7, **characterized in that** masking is provided for generating a desired symbol in the area to be illuminated.

9. Light module (1) according to one of Claims 1 to 8, **characterized in that** the flexible printed circuit board is constructed as a strip-shaped conductor track (3) in the region of the power lead.

10. Light module (1) according to one of the preceding claims, **characterized in that** the circuit carrier (2) which is formed by the flexible printed circuit board is integrated in the further flexible printed circuit board with the additional function.

11. Light module (1) according to one of Claims 1 to 9, **characterized in that** an interface (10) is provided between the further flexible printed circuit board with the additional function and the strip-shaped conductor track (3).

12. Light module (1) according to one of the preceding claims, **characterized in that** the additional function is a heating function, an antenna function, a current line function or other light function.

13. Use of a light module according to one of Claims 1 to 12 in a rear view mirror for motor vehicles.

14. Use according to Claim 13, **characterized in that** the light module is arranged directly below the mirrored glass surface of the rear view mirror.

15. Use according to Claim 13, **characterized in that** it is arranged in the mirror base plate of the rear view mirror.

16. Use according to one of Claims 13 to 15, **characterized in that** the light module is provided for blind spot angle display.

## Revendications

1. Module lumineux (1) pour affichage de signaux dans un rétroviseur d'un véhicule à moteur, comprenant un support de circuit (2), sur lequel sont agencés au moins une source lumineuse et éventuellement d'autres composants électroniques, et une alimentation électrique pour relier le support de circuit (2) avec une interface, agencée à distance du support de circuit (2), à des moyens de raccordement pour branchement à un générateur de courant/tension et/ou un dispositif de commande,
dans lequel le support de circuit (2) et l'alimentation électrique sont réalisés en une seule matière et en une seule pièce et sont formés par une plaque conductrice flexible,
dans lequel au moins une plaque conductrice additionnelle est prévue dotée d'au moins une fonction supplémentaire et dans lequel le support de circuit (2) est agencé sur la zone de bord de la plaque conductrice additionnelle, dépassant vers l'extérieur avec une piste conductrice en forme de bande (3) et peut être amené dans une position souhaitée en rabattant ou en repliant la piste conductrice en forme de bande (3),
**caractérisé en ce que** la plaque conductrice additionnelle comporte un évidement (9) et **en ce que** le support de circuit (2) peut être amené par repliement de la piste conductrice en forme de bande (3) dans la zone de l'évidement (9).

2. Module lumineux (1) selon la revendication 1, **caractérisé en ce que** les sources lumineuses comportent des LED SIDE et/ou TOP.

3. Module lumineux (1) selon la revendication 1 ou 2, **caractérisé en ce que** l'arrangement des sources lumineuses sur le support de circuit (2) est adapté au contour d'une surface à éclairer.

4. Module lumineux (1) selon l'une des revendications 1 à 3, **caractérisé en ce qu'**au moins un élément de mise en forme de lumière est prévu pour le réglage de l'angle de faisceau de la lumière.

5. Module lumineux (1) selon l'une des revendications 1 à 4, **caractérisé en ce que** le support de circuit (2), les sources lumineuses, les composants électroniques supplémentaires éventuellement présents et l'élément de mise en forme de lumière comportent une structure plate de type sandwich.

6. Module lumineux (1) selon la revendication 5, **caractérisé en ce que** l'élément de mise en forme de lumière scelle vers l'extérieur le support de circuit (2) doté des sources lumineuses et des composants électroniques supplémentaires éventuellement présents (5) .

7. Module lumineux (1) selon l'une des revendications 1 à 6, **caractérisé en ce qu'**un diffuseur (12) est prévu pour diffuser la lumière.

8. Module lumineux (1) selon l'une des revendications 1 à 7, **caractérisé en ce qu'**un masquage est prévu pour produire un symbole souhaité dans la surface à éclairer.

9. Module lumineux (1) selon l'une des revendications 1 à 8, **caractérisé en ce que** la plaque conductrice flexible est réalisée comme piste conductrice en forme de bande (3) dans la zone de l'alimentation électrique.

10. Module lumineux (1) selon l'une des revendications précédentes, **caractérisé en ce que** le support de circuit (2), lequel est formé par la plaque conductrice flexible, est intégré dans la plaque conductrice additionnelle flexible dotée de la fonction supplémentaire.

11. Module lumineux (1) selon l'une des revendications 1 à 9, **caractérisé en ce qu'**une interface (10) est prévue entre la plaque conductrice additionnelle flexible dotée de la fonction supplémentaire et la piste conductrice en forme de bande (3).

12. Module lumineux (1) selon l'une des revendications précédentes, **caractérisé en ce que** la fonction supplémentaire est une fonction de chauffage, d'antenne, de conduction du courant ou une autre fonction lumineuse.

13. Utilisation d'un module lumineux selon l'une des revendications 1 à 12 dans un rétroviseur pour véhicule à moteur.

14. Utilisation selon la revendication 13, **caractérisée en ce que** le module lumineux est agencé directement en dessous de la surface vitreuse réfléchissante du rétroviseur.

15. Utilisation selon la revendication 13, **caractérisée en ce qu'**il est agencé dans la base de miroir du rétroviseur.

16. Utilisation selon l'une des revendications 13 à 15, **caractérisé en ce que** le module lumineux est prévu pour l'affichage de l'angle mort.
